# EUROPEAN PATENT APPLICATION

(11) **EP 2 722 170 A1**
(43) Date of publication of application: **23.04.2014**
(21) Application number: 12800444.7
(22) Date of filing: 07.06.2012
(51) Int. Cl.: B32B 27/00, B05D 1/38, B05D 3/06, B05D 7/24, B32B 9/00, B32B 27/16, H01L 51/50, H05B 33/04

(54) **WATER-VAPOR BARRIER FILM, PROCESS FOR PRODUCING SAME, AND ELECTRONIC APPLIANCE INCLUDING SAME**

(30) Priority: 15.06.2011 JP 2011133045
(71) Applicant: Konica Minolta, Inc., Tokyo 100-7015 (JP)
(72) Inventor: ISHIKAWA, Wataru, Hachioji-shi Tokyo 192-8505 (JP)
(74) Representative: Green, Mark Charles
(86) International application number: PCT/JP2012/064694
(87) International publication number: WO 2012/173040

(57) **Abstract**

A water vapor barrier film that has high water vapor barrier performance, and further is excellent in water resistance, heat resistance, transparency, and smoothness; and a method for producing the same; and an electronic equipment using the same are provided. A water vapor barrier film containing at least one water vapor barrier layer, and at least one protective layer, on a base material having gas permeability, wherein the water vapor barrier layer is a layer formed by applying a coating liquid containing polysilazane, drying the applied coating liquid to form a film, and then by irradiating the film with vacuum ultraviolet light, and the protective layer is a layer formed by applying a coating liquid containing polysiloxane, drying the applied coating liquid to form a film, and then by irradiating the film with vacuum ultraviolet light.

## Description

### TECHNICAL FIELD

The present invention relates to a water vapor barrier film, and a method for producing the same, and an electronic equipment using the same.

### BACKGROUND ART

Conventionally, a gas barrier film in which a thin film (gas barrier layer) containing metallic oxide such as aluminum oxide, magnesium oxide, and silicon oxide is formed on a surface of a plastic substrate or a plastic film has been used for an intended use of packaging an article that requires cutoff of various gases of water vapor, oxygen, and the like in order to prevent deterioration caused by the various gases. Further, other than the above-described intended use for packaging, in order to prevent deterioration caused by various gases, a gas barrier film has also been used for an intended use of sealing an electronic device such as solar cells, a liquid crystal display element, and an organic electroluminescence element (hereinafter, referred to as an organic EL element). A.gas barrier film using a flexible base material is, as compared to a glass base material, excellent in flexibility and superior in terms of production suitability in a roll system, weight reduction of electronic device, and ease of handling.

As a method for producing such a gas barrier film, mainly, a method of forming a gas barrier layer on a base material such as a film by a plasma CVD method (Chemical Vapor Deposition: chemical vapor deposition method), a method of forming a gas barrier layer by applying a coating liquid that has polysilazane as the main component on a base material, and then performing a surface treatment, or a method using the above methods in combination, has been known.

However, in the gas barrier layer thus formed by these production methods, a defect of micropores generated due to the protrusion on a base material surface, or due to the contamination by foreign substances in the gas barrier layer, a defect of tiny cracks and the like generated due to the expansion and contraction of the gas barrier layer, a defect caused by the scratches attributed to the bending or contacting during handling, and the like, may be generated. In a gas barrier layer in which these defects have been generated, water vapor and the like are passed through the defected places, and thus the gases cannot be completely cut off.

On the other hand, in a liquid crystal display (LCD) panel, from the viewpoint of lightweight, not broken, and flexible, the glass base material is required to be replaced by a resin base material. However, against the glass base material, from the viewpoint of gas barrier property, transparency, and heat resistance, in the current situation, there is no such a resin base material satisfying all of the requirements of the gas barrier property, transparency, and heat resistance.

A resin base material having a gas barrier property used for a LCD panel undergoes a LCD production process, therefore, the resin base material has to be a base material maintaining the gas barrier property even after the LCD production process. Further, even in an environment where a LCD panel is used, the gas barrier property has to be maintained as well. In a LCD production process, as a step that affects the gas barrier property, there are a washing step by pure water, alkaline water, and the like, a heating step at around 200°C during preparation of pattern electrode (TCF), and the like. In addition, in an environment where LCD is used, there may be a case where the LCD is exposed to an environment of high temperature and high humidity. It is required to maintain the gas barrier property even in the high temperature and high humidity, the immersion in pure water, and the high temperature treatment, and also to maintain the other performance such as the transparency, and the base material deformation.

For such a problem of gas barrier layer, various improved techniques for suppressing the transmission of water vapor have been disclosed.

For example, in the invention described in Patent Literature 1, there is a disclosure of a technique in which in order to achieve the high water vapor barrier property, a water capturing layer is provided in addition to the gas barrier layer.

Further, in the invention described in Patent Literature 2, there is a disclosure of a technique in which in a water vapor barrier film having two layers of inorganic gas barrier layers, a hygroscopic layer consisting of at least one layer of alkaline earth metal monoxide is formed between the two layers of inorganic gas barrier layers to improve the water vapor barrier performance.

In addition, in the invention described in Patent Literature 3, there is a disclosure of a technique in which in a transparent laminate that is obtained by forming at least one metal nitride film on a transparent substrate, the metal nitride film may be oxidized in an atmosphere where at least oxygen molecules and/or water molecules are present.

Further, in the invention described in Patent Literature 4, there is a disclosure of a technique in which a hygroscopic film is sandwiched between moisture-proof films to improve the water vapor barrier property.

In addition, in the invention described in Patent Literature 5, there is a description of a method of laminating two or more layers of barrier layers in a barrier film having a barrier layer that contains Si atoms and oxygen atoms on a base material; or as a method of forming a barrier layer, a method of forming a barrier layer containing a silicon compound by applying a coating liquid containing a silicon compound on a base material, and then by irradiating the applied coating liquid base material with vacuum ultraviolet rays.

However, it was found that in all of these proposed gas barrier films and the like, gas barrier performance may be degraded due to the storage under high temperature and high humidity environment, the immersion in pure water, the high temperature treatment, and the like. Further, it was also found that there may be deformation, discoloration, or the like of gas barrier film due to the high temperature treatment, other than the gas barrier performance.

### Citation List

### Patent Literature

Patent Literature 1: JP-A-2009-90633
Patent Literature 2: JP-A-2006-82241
Patent Literature 3: JP-A-2009-29070
Patent Literature 4: JP-A-H07-153571
Patent Literature 5: JP-A-2011-31610

### SUMMARY OF INVENTION

### Technical Problem

The present invention has been made in view of the above problem, the problem is to provide a water vapor barrier film that has high water vapor barrier performance, and further is excellent in water resistance, heat resistance, transparency, and smoothness; and a method for producing the same; and an electronic equipment using the same.

### Solution to Problem

The above obj ect of the present invention is achieved by the following constitution.
1. A water vapor barrier film, containing: at least one water vapor barrier layer, and at least one protective layer, on a base material having gas permeability, wherein the water vapor barrier layer is a layer formed by applying a coating liquid containing polysilazane, drying the applied coating liquid to form a film, and then by irradiating the film with vacuum ultraviolet light, and the protective layer is a layer formed by applying a coating liquid containing polysiloxane, drying the applied coating liquid to form a film, and then by irradiating the film with vacuum ultraviolet light.
2. The water vapor barrier film described in the above 1, wherein the polysiloxane is a compound represented by the following general formula (a). 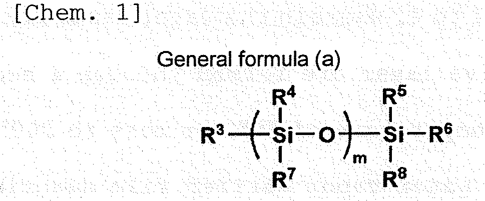 wherein each of R³ to R⁸ represents an organic group having 1 to 8 carbon atoms, each of which is the same as or different fromeachother. Herein, each of the R³ to R⁸ contains any of an alkoxy group and a hydroxyl group. m is 1 or more, and a weight average molecular weight is 1000 or more to 20000 or less in terms of polystyrene.
3. The water vapor barrier film described in the above 1 or 2, wherein a film thickness of the water vapor barrier layer is 50 nm or more to 1.0 µm or less, and a film thickness of the protective layer is 100 nm or more to 10 µm or less.
4. The water vapor barrier film described in any one of the above 1 to 3, wherein an accumulated light amount of the vacuum ultraviolet light used for a formation of the water vapor barrier layer is 1000 mJ/cm² or more to 10,000 mJ/cm² or less, and an accumulated light amount of the vacuum ultraviolet light used for a formation of the protective layer is 500 mJ/cm² or more to 10,000 mJ/cm² or less.
5. The water vapor barrier film described in any one of the above 1 to 4, wherein the water vapor barrier layer and the protective layer are formed through a heating step with a heating temperature of 50°C or more to 200°C or less.
6. The water vapor barrier film described in any one of the above 1 to 5, wherein the base material has a linear expansion coefficient of 50 ppm/°C or less and a total light transmittance of 90% or more.
7. A method for producing a water vapor barrier film, containing: forming a water vapor barrier layer by applying a coating liquid containing polysilazane on a base material having gas permeability, drying the applied coating liquid to form a film, and then by irradiating the film with vacuum ultraviolet light; and forming a protective layer by applying a coating liquid containing polysiloxane on the water vapor barrier layer, drying the applied coating liquid to form a film, and then by irradiating the film with vacuum ultraviolet light.
8. An electronic equipment, containing an electronic device sealed with the water vapor barrier film described in any one of the above 1 to 6, or a water vapor barrier film produced by the method described in the above 7.

### Effect of Invention

According to the present invention, a water vapor barrier film that has high water vapor barrier performance, and further is excellent in water resistance, heat resistance, transparency, and smoothness; and a method for producing the same; and an electronic equipment using the same can be provided.

### BRIEF DESCRIPTION OF DRAWINGS

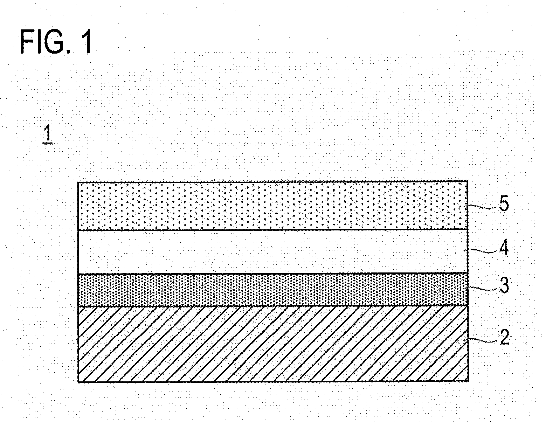

Fig. 1 is a sectional view showing an example of a typical constitution of the water vapor barrier film of the present invention.

### DESCRIPTION OF EMBODIMENTS

Hereinafter, the embodiments for carrying out the present invention will be explained in more detail.

As a result of the intensive studies by the present inventors in view of the above problems, it was found that a water vapor barrier film that has high water vapor barrier performance, and further is excellent in water resistance, heat resistance, transparency, and smoothness can be realized by using a water vapor barrier film containing at least one water vapor barrier layer, and at least one protective layer, on a base material having gas permeability, in which the water vapor barrier layer is a layer formed by applying a coating liquid containing polysilazane, drying the applied coating liquid to form a film, and then by irradiating the film with vacuum ultraviolet light, and the protective layer is a layer formed by applying a coating liquid containing polysiloxane, drying the applied coating liquid to form a film, and then by irradiating the film with vacuum ultraviolet light; and thus the present invention has been completed.

Hereinafter, the water vapor barrier film according to the present invention, and the production method of the same will be explained in more detail.

Fig. 1 is a sectional view showing an example of a typical constitution of the water vapor barrier film of the present invention.

In Fig. 1, a water vapor barrier film 1 of the present invention has at least one water vapor barrier layer 4, and at least one protective layer 5, on a base material 2.

The water vapor barrier layer 4 according to the present invention is a barrier layer consisting of a polysilazane modified layer that is formed by applying a coating liquid containing polysilazane, drying the applied coating liquid to form a film, and then by irradiating the film with vacuum ultraviolet light. Further, the protective layer 5 according to the present invention is a protective layer consisting of a polysiloxane modified layer that is formed by applying a coating liquid containing polysiloxane, drying the applied coating liquid to form a film, and then by irradiating the film with vacuum ultraviolet light.

In addition, in order to improve the smoothness of base material 2, and the adhesion of water vapor barrier layer 4 to a base material 2, as needed, a smooth layer or an anchor coat layer can be provided on the base material surface as an intermediate layer 3.

Hereinafter, the constitution of the water vapor barrier film according to the present invention will be explained in more detail.

### [Base material]

The base material 2 that constitutes the water vapor barrier film of the present invention and has gas permeability is preferably a film base material that has flexibility and can be bent. This base material 2 is not particularly limited, as long as the base material 2 is a base material in a film form, which can hold a water vapor barrier layer having a water vapor barrier property, and a protective layer protective layer.

Herein, "having gas permeability" referred to in the present invention, is defined that the water vapor permeability measured based on K7129 of JIS standard (temperature 40°C, and humidity 90%RH) by using PERMATRAN-W3/33 manufactured by MOCON in accordance with a MOCON method is 0.5 g/m²/day or more.

In addition, the base material used in the present invention may be a base material laminated with various intermediate layers such as an anchor coat layer or a smooth layer, on a base material.

As a resin material applicable to the base material 2 according to the present invention, for example, a resin film consisting of a resin material of acrylic acid ester, methacrylic acid ester, polyethylene terephthalate (PET), polybutylene terephthalate, polyethylene naphthalate (PEN), polycarbonate (PC), polyarylate, polyvinyl chloride (PVC), polyethylene (PE), polypropylene (PP), polystyrene (PS), nylon (Ny), aromatic polyamide, polyether ether ketone, polysulfone, polyether sulfone, polyimide, polyetherimide, and the like; a heat-resistant transparent film in which silsesquioxane having an organic-inorganic hybrid structure is used as a basic skeleton (Product name: Silplus, manufactured by Nippon Steel Chemical Co., Ltd.); further a laminated resin film that is constituted by laminating two or more layers of the above-described resin films; and Lhe like may be used.

Among these resin films, from the viewpoints of ease of availability and cost, a film of polyethylene terephthalate (PET), polybutylene terephthalate, polyethylene naphthalate (PEN), polycarbonate (PC), and the like is preferably used.

Further, in the case where high temperature treatment is required during a processing step of sealing the device, a transparent film of polyimide, in which the heat resistance and the transparency are balanced with each other, for example, a transparent polyimide-based film, type HM manufactured by Toyobo Co.,Ltd., or a transparent polyimide-based film, Neopulim L L-3430 manufactured by Mitsubishi Gas Chemical Company, Inc., and the like can be preferably used.

The thickness of the base material according to the present invention is preferably around 5 to 500 µm, and more preferably 25 to 250 µm.

Further, the linear expansion coefficient of the base material according to the present invention is preferably 50 ppm/°C or less, and more preferably 1 ppm/°C or more to 50 ppm/°C or less.

By the application of a base material having a linear expansion coefficient of 50 ppm/°C or less, when a liquid crystal display (LCD) panel is used as a substrate, the occurrence of color shift for the environmental temperature changes and the like can be suppressed.

As the linear expansion coefficient defined in the present invention, the value determined in accordance with the following method can be employed. More specifically, by using a thermal stress-strain measuring device, EXSTAR TMA/SS6000 type manufactured by Seiko Instruments Inc., the temperature of a base material to be measured is increased from 30°C to 50°C at a rate of 5°C per minute under a nitrogen atmosphere, and then holds once, is increased again at a rate of 5°C per minute, and at 30°C to 150°C, the linear expansion coefficient is measured and determined. The measurement was performed at tensile mode under a load of 5 g.

Further, the total light transmittance of the base material according to the present invention is preferably 90% or more. By the application of a base material having a total light transmittance of 90% or more, when a liquid crystal display (LCD) panel is used as a substrate, the high brightness can be obtained.

"Total light transmittance" referred to in the present invention, means an average transmittance in the visible light region, which is obtained by measuring the total amount of transmitted light to the amount of incident light of visible light in accordance with ASTM D-1003 standard by using a spectrophotometer (an ultraviolet visible spectrophotometer, UV-2500PC manufactured by Shimadzu Corporation).

Further, the base material using a resin material may be an unstretched film, or may be a stretched film.

The base material consisting of the above-described resin material can be produced by a conventionally known general production method. For example, an unstretched base material that is substantially amorphous and not oriented can be produced by melting a resin to be the material by an extruder, extruding the melted resin by an annular die or a T die, and cooling the extruded resin rapidly. Further, a stretched base material can be produced by stretching an unstretched base material in a flow (vertical axis) direction of the base material, or in a direction perpendicular to the flow direction of the base material (horizontal axis), by a known method such as uniaxial stretching, tenter successive biaxial stretching, tenter simultaneous biaxial stretching, and a tubular simultaneous biaxial stretching. The stretch ratio in this case can be appropriately selected according to the resin to be a material of the base material, however, each stretch ratio in a vertical axis direction and in a horizontal axis direction is preferably 2 to 10 times.

Hereinafter, each of the constituent layers of the water vapor barrier film of the present invention will be explained in more detail.

### [Water vapor barrier layer]

The present invention is characterized in that a water vapor barrier layer contains a polysilazane modified layer. The polysilazane modified layer is formed by a wet coating method in which a coating liquid containing polysilazane (herein after, also referred to as "a polysilazane-containing coating liquid") is applied on a base material (in the case where an intermediate layer is formed on a base material, on the base material or on the intermediate layer), dried to form a film, and then the obtained coated film is irradiated with vacuum ultraviolet light.

The "polysilazane" applied to form a water vapor barrier layer according to the present invention is a polymer having a silicon-nitrogen bond, and a ceramic precursor inorganic polymer of SiO₂, Si₃N₄, an intermediate solid solution SiOₓN_{y} of SiO₂ and Si₃N₄, and the like, which contain a bond of Si-N, Si-H, N-H, and the like.

As a method for applying a polysilazane-containing coating liquid, a wet application method that is appropriate and conventionally known may be employed. Specifically, examples of the method include a spin coating method, a roll coating method, a flow coating method, an inkjet method, a spray coating method, a printing method, a dip coating method, a casting film forming method, a bar coating method, and a gravure printing method.

The film thickness of a water vapor barrier film can be appropriately set according to the purpose. For example, the film thickness of a water vapor barrier layer is preferably around 10 nm to 10 µm, and more preferably 50 nm to 1 µm. If the film thickness of a water vapor barrier layer is 10 nm or more, a sufficient barrier property can be obtained, and if the film thickness of a water vapor barrier layer is 10 µm or less, a stable coating property can be obtained during the formation of water vapor barrier layer, and high light transmittance can be realized.

Further, the water vapor barrier layer according to the present invention is preferably formed through a heating step. A heating temperature of the heating step is preferably 50°C or more to 200°C or less. If the heating temperature is 50°C or more, a sufficient barrier property can be obtained, and if the heating temperature is 200°C or less, a water vapor barrier layer having high smoothness can be formed without giving any deformation to the base material.

In the heating method used in the heating step, a hot plate, an oven, a furnace, and the like can be used, and as the heating atmosphere, under an atmosphere, under a nitrogen atmosphere, under an argon atmosphere, under a vacuum, under reduced pressure in which oxygen concentration is controlled, and the like, the heating step can be performed.

Further, as the polysilazane, in order to apply so as not to impair the nature of the base material, a compound that is ceramic-formed at a relatively low temperature and is modified to silica is preferable, for example, a compound having a main skeleton consisting of units, each of the units is represented by the following general formula (1) described in JP-A-H08-112879 is preferable.

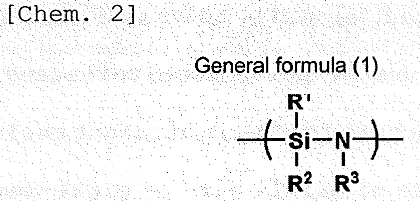

In the above general formula (1), each of R¹, R², and R³ independently represents a hydrogen atom, an alkyl group, an alkenyl group, a cycloalkyl group, an aryl group, an alkylsilyl group, an alkylamino group, or an alkoxy group.

In the present invention, from the viewpoint of the denseness as the water vapor barrier layer to be obtained, perhydropolysilazane in which all of R¹, R², and R³ represent a hydrogen atom is particularly preferable.

Further, organopolysilazane in which part of the hydrogen atom portion that bonds to the Si is substituted with an alkyl group or the like, has the advantage that the adhesion to the base material and the like that are a foundation can be improved by containing an alkyl group such as a methyl group, and the toughness can be imparted to a ceramic film by the polysilazane that is hard and brittle, and thus even if the film thickness (average film thickness) of the organopolysilazane is made thicker, occurrence of cracks can be suppressed. Therefore, depending on the application, perhydropolysilazane and organopolysilazane may be appropriately selected, or may be used as a mixture thereof.

The structure of perhydropolysilazane has been estimated to be a structure in which a straight chain structure and a cyclic structure of mainly six- to eight-membered ring exist. The molecular weight is around 600 to 2000 in number average molecular weight (Mn) (in terms of polystyrene), the substance exists in a liquid or a solid form, and the state varies depending on the molecular weight. This perhydropolysilazane is commercially available in a solution state that is dissolved in an organic solvent, and the commercially available product can be used as it is as a polysilazane-containing coating liquid.

Other examples of the polysilazane that is ceramic-formed at a relatively low temperature include: silicon alkoxide-addition polysilazane obtained through a reaction of the polysilazane having a main skeleton consisting of units, each of the units is represented by the above-described general formula (1) with silicon alkoxide (see, for example, JP-A-H05-238827); glycidol-addition polysilazane obtained through a reaction of the above polysilazane with glycidol (see, for example, JP-A-H06-122852); alcohol-addition polysilazane obtained through a reaction of the above polysilazane with alcohol (see, for example, JP-A-H06-240208); metal carboxylate-addition polysilazane obtained through a reaction of the above polysilazane with metal carboxylate (see, for example, JP-A-H06-299118); acetylacetonate complex-addition polysilazane obtained through a reaction of the above polysilazane with acetylacetonate complex containingmetal (see, for example, J JP-A-H06--306329) ; metal particle-addition polysilazane obtained through a reaction of the above polysilazane with metal particles (see, for example, JP-A-H07-196986); and the like.

As an organic solvent contained in the polysilazane-containing coating liquid, a solvent other than the alcohol and water that have the characteristics of reacting easily with polysilazane is preferably used. Therefore, specifically, a hydrocarbon solvent of aliphatic hydrocarbon, cyclic hydrocarbon, aromatic hydrocarbon, and the like; a halogenated hydrocarbon solvent; and ethers such as aliphatic ether, and cyclic ether, can be used. Specifically the examples include hydrocarbon such as pentane, hexane, cyclohexane, toluene, xylene, solvesso, and turpentine; halogenated hydrocarbon such as methylene chloride, and trichloroethane; and ethers such as dibutylether, dioxane, and tetrahydrofuran. These organic solvents are selected depending on the characteristics such as the solubility of polysilazane, the evaporation rate of an organic solvent, and the like, and multiple organic solvents may be mixed to be used.

The polysilazane concentration in the polysilazane-containing coating liquid varies depending on the film thickness of the intended polysilazane modified layer, or the pot life of the coating liquid, however, the concentration is preferably around 0.2 to 35 % by mass.

Into the polysilazane-containing coating liquid, in order to promote the conversion to a silicon oxide compound, a catalyst of amine or metal can also be added. Specifically the examples include AQUAMICA NAX120-20, AQUAMICA NN110, AQUAMICA NN310, AQUAMICA NN320, AQUAMICA NL110A, AQUAMICA NL120A, AQUAMICA NL150A, AQUAMICA NP110, AQUAMICA NP140, and AQUAMICA SP140, which are manufactured by AZ Electronic Materials.

In the coated film formed by the polysilazane-containing coating liquid that is used for the present invention, the amount of water before or during the modification treatment is preferably controlled by vacuum ultraviolet light irradiation.

Before or during the modification treatment with vacuum ultraviolet light irradiation, as a source of water that may enter the polysilazane modified layer, for example, there is migration from the base material surface, or absorption of water vapor in the atmosphere. The water amount to migrate to a polysilazane modified layer from the base material side can be controlled by storage of the base material under a certain temperature and humidity environment before the application of a polysilazane-containing coating liquid to control the water content of the base material to a desired level. The desired level varies depending on the humidity in the atmosphere described below, however, usually 1000 ppm or less, and preferably 300 ppm or less in terms of mass.

In the step of applying a polysilazane-containing coating liquid on a base material and drying the applied coating liquid, in order to remove mainly the organic solvent, the drying can be appropriately performed by a heating treatment and the like. The heating treatment is preferably performed at high temperature in a short time, however, in consideration of the thermal damage to the base material that is a resin film, the temperature and the treating time are preferably appropriately determined. For example, in the case where as a base material, a polyethylene terephthalate base material having a glass transition temperature (Tg) of 70°C, the heating treatment temperature is preferably set to 150°C or less. The treating time is preferably set to a short time in order to remove the solvent and so as to reduce the thermal damage to the base material, and if the heating treatment temperature is 150°C or less, the treating time can be set to 30 minutes or less.

The atmosphere in the step of applying a polysilazane-containing coating liquid on a base material and drying the applied coating liquid is preferably controlled to a relatively low humidity, however, the humidity in the low-humidity environment varies depending on the temperature, therefore, the relationship of the temperature and the humidity is preferably shown pursuant to the provision of the dew-point temperature. The preferred dew-point temperature is 4°C or less (temperature 25°C / humidity 25%), the more preferred dew-point temperature is -8°C (temperature 25°C / humidity 10%) or less, and the furthermore preferred dew-point temperature is -31°C (temperature 25°C / humidity 1%) or less. Further, in order to easily remove the water, the drying may be performed under reduced pressure. The pressure in the drying under reduced pressure can be selected from the normal pressure to 0.1 MPa.

### <Modification treatment of polysilazane: vacuum ultraviolet light irradiation treatment>

The modification treatment of polysilazane in the present invention means a reaction for the conversion of part or all of the polysilazane compounds to silicon oxide or silicon nitride oxide.

In the modification treatment, a known method based on the conversion reaction of polysilazane can be selected. In the formation of a silicon oxide film or a silicon nitride oxide film by the substitution reaction of polysilazane compound, a high temperature of 450°C or more is required, therefore, in a flexible substrate in which a resin film is used as a base material, the adaptation is difficult. Accordingly, when the water vapor barrier film of the present invention is prepared, from the viewpoint of the application to a plastic substrate, as the method to be employed, it is characterized to apply a method of modification by the irradiation with the vacuum ultraviolet light that is capable of a conversion reaction at a lower temperature.

In the production method of water vapor barrier film according to the present invention, the coated film obtained by applying a polysilazane-containing coating liquid, and drying the applied coating liquid, is modified by the treatment of the irradiation with vacuum ultraviolet light. The ozone or active oxygen atoms generated by the ultraviolet rays (same meaning as ultraviolet light) has a high oxidation capacity, and thus a silicon oxide film or a silicon nitride oxide film, which has high denseness and insulation at a low temperature, can be formed. In addition, the vacuum ultraviolet light referred to in the present invention, means ultraviolet light including electromagnetic waves with a wavelength of 10 to 200 nm.

By the vacuum ultraviolet light irradiation, O₂ and H₂O that contribute to the ceramic forming, an ultraviolet absorber, and the polysilazane itself are excited and activated. Further, the ceramic forming of the excited polysilazane is promoted, and the obtained ceramics film becomes dense. The vacuum ultraviolet light irradiation is effective even if the vacuum ultraviolet light irradiation is performed at any point in time as long as the vacuum ultraviolet light irradiation is performed after the formation of the coated film.

In the vacuum ultraviolet light irradiation treatment in the present invention, any of the ultraviolet ray generators that are commonly used can also be used.

In the irradiation of vacuum ultraviolet light, the irradiation strength and the irradiation time are preferably set in the range that the base material 2 supporting the polysilazane layer to be irradiated before modification does not receive any damages.

Taking the case where a plastic film is used as the base material as an example, for example, by using a lamp of 2 kW (80 W/cm x 25 cm), and by setting the distance between the base material and the vacuum ultraviolet irradiation lamp so that the strength of the base material surface is 20 to 300 mW/cm², and preferably 50 to 200 mW/cm², the irradiation can be performed for 0.1 second to 10 minutes.

Further, in the present invention, the accumulated light amount of the vacuum ultraviolet light when a water vapor barrier layer is formed by modifying a polysilazane layer is preferably 1,000 mJ/cm² or more to 10,000 mJ/cm² or less. If the accumulated light amount of the vacuum ultraviolet light is 1000 mJ/cm² or more, sufficient barrier performance can be obtained, and if the accumulated light amount is 10, 000 mJ/cm² or less, a water vapor barrier layer having high smoothness can be formed without giving any deformation to the base material.

In general, if the base material temperature during the ultraviolet irradiation becomes 150°C or more, in the case where the base material is a plastic film and the like, the characteristics of the base material may be impaired, that is, the base material deforms, the strength is degraded, and the like. However, in the case of a film and the like that have high heat resistance and are made of polyimide and the like, modification treatment at a higher temperature can be performed. Therefore, as the base material temperature during the ultraviolet irradiation, there is no general upper limit, and the base material temperature can be appropriately set depending on the kind of base material by a person skilled in the art. In addition, the ultraviolet irradiation atmosphere is not particularly limited, and thus the ultraviolet irradiation may be performed in air.

As a measure for generating such vacuum ultraviolet rays, for example, an excimer lamp and the like can be included. Further, when the generated ultraviolet rays are irradiated to a polysilazane layer before the modification, from the viewpoint of the efficiency improvement and the achievement of uniform irradiation, the ultraviolet rays from a generation source are reflected by a reflecting plate and then the reflected rays are applied on a polysilazane layer before the modification.

The vacuum ultraviolet irradiation is also applicable to a batch processing and to a continuous processing, and thus the processing can appropriately be selected depending on the shape of the base material to be used. In the case where the base material is in the shape of a long-length film, while conveying the base material, ultraviolet rays are continuously irradiated to the base material in a drying zone where the above-described generation source of ultraviolet rays is provided, and thus ceramic can be formed. The time required for ultraviolet irradiation is, through depending on the base material to be used, and the composition and concentration of the polysilazane modified layer, generally 0.1 second to 10 minutes, and preferably 0. 5 second to 3 minutes.

Further, the oxygen concentration when the vacuum ultraviolet light (VUV) according to the present invention is irradiated is set to preferably 300 ppm to 10000 ppm (1%), and more preferably 500 ppm to 5000 ppm. By the adjustment of the oxygen concentration in such a range described above, the formation of a hyperoxic water vapor barrier layer 4 is prevented, and thus the degradation of the barrier property can be prevented.

As the gas other than the oxygen described above during the vacuum ultraviolet light (VUV) irradiation, dry inert gas is preferably used, and particularly, from the viewpoint of cost, dry nitrogen gas is preferably used.

The oxygen concentration can be adjusted by measuring the flow rate of the oxygen gas and inert gas to be introduced into an irradiation chamber, and by changing the flow ratio.

In the present invention, as described above, the modification treatment is performed by vacuum ultraviolet light irradiation. The treatment by vacuum ultraviolet light irradiation is a process of forming a silicon oxide film at a relatively low temperature by using a light energy with a wavelength of 100 to 200 nm that is larger than the atomic bonding force in a polysilazane compound, preferably a light energy with a wavelength of 100 to 180 nm, by the action of only photons called photon process, and by conducting the oxidation reaction with active oxygen or ozone while directly cutting the bonding between atoms. As the vacuum ultraviolet light source required for this, a rare gas excimer lamp is preferably used.

In addition, a rare gas atom such as Xe, Kr, Ar, and Ne does not form a molecule by the chemical bonding, therefore, such a rare gas is called an inert gas. However, an atom of rare gas, which has obtained energy by the discharge or the like (excited atom), can form a molecule by the bonding with other atoms. For example, in the case where the rare gas is xenon,

e + Xe → Xe*,

Xe* + 2Xe → Xe₂* + Xe,

and

Xe₂* → Xe + Xe + hv (172 nm),

are conducted, and when the Xe₂* that is an excited excimer molecule is transited to the ground state, excimer light (vacuum ultraviolet light) with a wavelength of 172 nm is emitted.

As a characteristic of the excimer lamp, radiation concentrates on one wavelength, light other than the necessary light is little emitted, and thus the high efficiency, and the like can be described. Further, extra light is not emitted, therefore, the temperature of the object can be maintained at a low temperature. Furthermore, the time is not required for the starting and the restarting, therefore, instant lighting or flashing can be performed.

In order to obtain the excimer light emission, a method of using dielectric barrier discharge has been known. The dielectric barrier discharge is discharge called very fine micro discharge that is similar to lightning occurring in a gas space, by the arrangement of the gas space between both electrodes via a dielectric (transparent quartz in the case of an excimer lamp), and by the application of high voltage with a high frequency of several tens of kHz to electrodes.

Further, as a method of efficiently obtaining excimer light emission, electrodeless field discharge other than the dielectric barrier discharge has also been known. Electrodeless field discharge is discharge by capacitive coupling, and is also called RF discharge as another name. Lamp, electrodes, and arrangement of the lamp and the electrodes may be basically the same as those in the dielectric barrier discharge, however, the high frequency to be applied between both electrodes is turned on at several MHz. In the electrodeless field discharge, uniform discharge can be obtained specially and also temporally as described above.

In addition, a Xe excimer lamp emits ultraviolet rays with a single short wavelength of 172 nm, and thus the Xe excimer lamp is excellent in luminous efficiency. This light has a large absorption coefficient of oxygen, therefore, radical oxygen atomic species and ozone can be generated at high concentration with a minute amount of oxygen. Further, it is known that light energy with a short wavelength of 172 nm has high potential to dissociate the bonding of an organic substance. Modification of a polysilazane film can be realized in a short time by these active oxygen and ozone, and the high energy possessed by ultraviolet radiation. Accordingly, as compared with a low pressure mercury lamp emitting ultraviolet rays with a wavelength of 185 nm or 254 nm, and plasma cleaning, reduction of the processing time along with high throughput, reduction of the facilities area, and irradiation to an organic material, a plastic substrate, a resin film, and the like that are easily damaged by heat, can be realized.

In addition, an excimer lamp has a high generation efficiency of light, therefore, the excimer lamp can be turned on by the supply of low electric power. Further, the excimer lamp does not emit any light with a long wavelength, which can be a cause of temperature increase by the light, and irradiates with energy with a single wavelength in an ultraviolet region, therefore, there is a feature that the increase of surface temperature of the obj ect to be irradiated can be suppressed. Accordingly, the excimer lamp is suitable for the irradiation to a water vapor barrier film in which a resin film of polyethylene terephthalate and the like that is susceptible to be affected by heat is used as the base material.

### [Protective layer]

Hereinafter, the protective layer according to the present invention will be explained in more detail.

The present invention is characterized in that a protective layer contains a polysiloxane modified layer. The polysiloxane modified layer is formed by a wet coating method in which a coating liquid containing polysiloxane (herein after, also referred to as "a polysilazane-containing coating liquid") is applied on the water vapor barrier layer, dried to form a film, and then the obtained coated film is irradiated with vacuum ultraviolet light.

The polysiloxane-containing coating liquid contains mainly polysiloxane and an organic solvent.

As the polysiloxane applicable to the formation of the protective layer according to the present invention, there is no particular limitation, however, the organopolysiloxane represented by the following general formula (a) is particularly preferred.

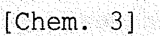

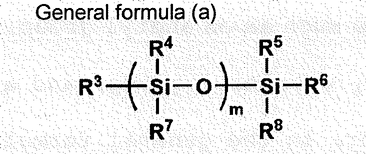

In the above general formula (a), each of R³ to R⁸ represents an organic group having 1 to 8 carbon atoms each of which is the same as or different from each other. Each of the R³ to R⁸ contains any of an alkoxy group and a hydroxyl group.

Examples of the organic group having 1 to 8 carbon atoms, and represented by the R³ to R⁸ include: for example, a halogenated alkyl group such as a γ-chloropropyl group, and a 3,3,3-trifluoropropyl group; a (meth)acrylic acid ester group such as a vinyl group, a phenyl group, and a γ-methacryloxypropyl group; an epoxy-containing alkyl group such a γ-glycidoxypropyl group;a mercapto-containing alkyl group such as a γ-mercaptopropyl group; an aminoalkyl group such as a γ-aminopropyl group; an isocyanate-containing alkyl group such as a γ-isocyanatepropyl group; a straight or branched alkyl group such as a methyl group, an ethyl group, an n-propyl group, and an isopropyl group; an alicyclic alkyl group such as a cyclohexyl group, and a cyclopentyl group; a straight or branched alkoxy group such as a methoxy group, an ethoxy group, an n-propoxy group, and an isopropoxy group; and an acyl group such as an acetyl group, a propionyl group, a butyryl group, a valeryl group, and a caproyl group.

Further, in the general formula (a) according to the present invention, particularly, preferably, m is 1 or more, and a weight average molecular weight is 1, 000 to 20, 000 in terms of polystyrene. If the weight average molecular weight of the organopolysiloxane is 1,000 or more in terms of polystyrene, cracks hardly occur in the protective layer to be formed, and thus the water vapor barrier property can be maintained; and if the weight average molecular weight of the organopolysiloxane is 20,000 or less in terms of polystyrene, curing of the protective layer to be formed becomes sufficient, and thus sufficient hardness can be obtained for the protective layer to be obtained.

Examples of the organic solvent applicable to the present invention include an alcohol-based solvent, a ketone-based solvent, an amide-based solvent, an ester-based solvent, and a non-protonated solvent.

Herein, as the alcohol-based solvent, n-propanol, iso-propanol, n-butanol, iso-butanol, sec-butanol, tert-butanol, n-pentanol, iso-pentanol, 2-methylbutanol, sec-pentanol, tert-pentanol, 3-methoxybutanol, n-hexanol, 2-methylpentanol, sec-hexanol, 2-ethylbutanol, propylene glycol monomethyl ether, propylene glycol monoethyl ether, propylene glycol monopropyl ether, propylene glycol monobutyl ether, and the like are preferable.

Examples of the ketone-based solvent include, in addition to acetone, methyl ethyl ketone, methyl-n-propyl ketone, methyl-n-butyl ketone, diethyl ketone, methyl-iso-butyl ketone, methyl-n-pentyl ketone, ethyl-n-butyl ketone, methyl-n-hexyl ketone, di-iso-butyl ketone, trimethyl nonanone, cyclohexanone, 2-hexanone, methyl cyclohexanone, 2,4-pentanedione, acetonylacetone, acetophenone, fenchone, and the like, β-diketones such as acetylacetone, 2,4-hexanedione, 2,4-heptanedione, 3,5-heptanedione, 2,4-octanedione, 3,5-octanedione, 2,4-nonanedione, 3,5-nonanedione, 5-methyl-2,4-hexanedione, 2,2,6,6-tetramethyl-3,5-heptanedione, and 1,1,1,5,5,5-hexafluoro-2,4-heptanedione.

Examples of the amide-based solvent include formamide, N-methylformamide, N,N-dimethylformamide, N-ethylformamide, N,N-diethylformamide, acetamide, N-methylacetamide,N,N-dimethylacetamide,N-ethylacetamide, N,N-diethylacetamide, N-methylpropionamide, N-methylpyrrolidone, N-formylmorpholine, N-formylpiperidine, N-formylpyrrolidine, N-acetylmorpholine, N-acetylpiperidine, and N-acetylpyrrolidine.

Examples of the ester-based solvent include diethyl carbonate, ethylene carbonate, propylene carbonate, diethyl carbonate, methyl acetate, ethyl acetate, γ-butyrolactone, γ-valerolactone, n-propyl acetate, iso-propyl acetate, n-butyl acetate, iso-butyl acetate, sec-butyl acetate, n-pentylacetate, sec-pentylacetate, 3-methoxybutylacetate, methylpentyl acetate, 2-ethylbutyl acetate, 2-ethylhexyl acetate, benzyl acetate, cyclohexyl acetate, methyl cyclohexyl acetate, n-nonyl acetate, methyl acetoacetate, ethyl acetoacetate,ethylene glycolmonomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate.

Examples of the non-protonated solvent include acetonitrile, dimethyl sulfoxide, N,N,N',N'-tetraethyl sulfamide, hexamethylphosphoric triamide, N-methylmorphorone, N-methylpyrrole, N-ethylpyrrole, N-methylpiperidine, N-ethylpiperidine, N,N-dimethylpiperazine, N-methylimidazole, N-methyl-4-piperidone, N-methyl-2-piperidone, N-methyl-2-pyrrolidone, 1,3-dimethyl-2-imidazolidinone, and 2,3-dimethyltetrahydro-2-(1H)-pyrimidinone.

The above-described organic solvents may be used in one kind alone or by mixing two or more kinds thereof.

As the organic solvent, among the above-described organic solvents, an alcohol-based solvent is preferable.

Examples of the application method of polysiloxane-containing coating liquid include a spin coating method, a dipping method, a roller blade method, and a spraying method.

The film thickness of the protective layer is preferably in the range of 100 nm to 10 µm. If the film thickness of the protective layer is 100 nm or more, the barrier property under high humidity can be ensured, and if the film thickness is 10 µm or less, the stable coating property can be obtained during the formation of the protective layer, and the high light transmittance can be realized.

Further, the film density of the protective layer is usually 0.35 to 1.2 g/cm³, preferably 0.4 to 1.1 g/cm³, and more preferably 0.5 to 1.0 g/cm³. If the film density is 0.35 g/cm³ or more, sufficient mechanical strength of the coated film can be obtained.

As the vacuum ultraviolet light used when the coated film obtained by a polysiloxane-containing coating liquid is converted to a polysiloxane modified film, a vacuum ultraviolet light irradiation treatment that is the same as that explained above in the formation of water vapor barrier layer can be applied.

Further, the accumulated light amount of the vacuum ultraviolet light when a protective layer is formed by modifying a polysiloxane layer according to the present invention is preferably 500 mJ/cm² or more to 10,000 mJ/cm² orless. If the accumulated light amount of vacuumultraviolet light is 500 mJ/cm² or more, sufficient barrier performance can be obtained, and if the accumulated light amount is 10,000 mJ/cm² or less, a protective layer having high smoothness can be formed without giving any deformation to the base material.

In addition, the protective layer according to the present invention is preferably formed through a heating step. A heating temperature of the heating step is preferably 50°C or more to 200°C or less. If the heating temperature is 50°C or more, a sufficient barrier property can be obtained, and if the heating temperature is 200°C or less, a protective layer having high smoothness can be formed without giving any deformation to the base material.

In the heating method used in the heating step, a hot plate, an oven, a furnace, and the like can be used, and as to the heating atmosphere, under an atmosphere, under a nitrogen atmosphere, under an argon atmosphere, under a vacuum, under reduced pressure in which oxygen concentration is controlled, and the like, the heating method can be performed.

### [Other constituent layers]

Subsequently, constituent layers that are applicable to the water vapor barrier film of the present invention, other than the water vapor barrier layer and the protective layer will be explained. As the constituent layer, an intermediate layer that is provided on a base material, such as an anchor coat layer, a smooth layer, and a bleed-out preventing layer, is included.

### (Anchor coat layer)

In the water vapor barrier film of the present invention, from the viewpoint of the improvement of the adhesion of water vapor barrier layer 4 and base material 2, and of the obtaining of the high smoothness, as needed, an anchor coat layer may be formed on a base material 2.

As an anchor coat agent used for the formation of the anchor coat layer, a polyester resin, an isocyanate resin, a urethane resin, an acrylic resin, an ethylene vinyl alcohol resin, a modified vinyl resin, an epoxy resin, a modified styrene resin, a modified silicone resin, alkyl titanate, and the like can be used. The anchor coat agent may be used alone or in combination of two or more kinds thereof. Further, into these anchor coat agents, a conventionally known additive can also be added.

The above-described anchor coat agents are applied on a base material by a known method such as a roll coating method, a gravure coating method, a knife coating method, a dip coating method, and a spray coating method, the solvent, the diluent, and the like are dried and removed, and thus an anchor coat layer can be formed.

The application amount of the anchor coating agent is preferably around 0.1 to 5 g/m² in a dry state.

### (Smooth layer)

In addition, in the water vapor barrier film of the present invention, a smooth layer may be provided on a base material. The smooth layer is formed on one surface or both surfaces of a base material.

The smooth layer is provided so that the rough surface of the base material on which minute protrusions and the like are present is planarized, and irregularities and pinholes are not generated on the water vapor barrier layer that forms on the base material by protrusions and the like of the base material surface. Such a smooth layer can be formed, for example, by the curing of a photosensitive resin.

Examples of the photosensitive resin used for the formation of the smooth layer include, for example, a resin composition containing an acrylate compound having a radical reactive unsaturated bond, a resin composition containing a mercapto compound having an acrylate compound and a thiol group, and a resin composition obtained by dissolving a polyfunctional acrylate monomer such as epoxy acrylate, urethane acrylate, polyester acrylate, polyether acrylate, polyethylene glycol acrylate, and glycerol methacrylate. Further, any mixture of the above-described resin compositions can be used, and the photosensitive resin is not particularly limited as long as the photosensitive resin is a photosensitive resin that contains a reactive monomer having one or more of photopolymerizable unsaturated bond in the molecule. The reactive monomer can be used in one kind alone, as a mixture of two or more kinds, or as a mixture with other compounds.

Further, the composition of a photosensitive resin contains a photopolymerization initiator. The photopolymerization initiator can be used in one kind alone or in combination of two or more kinds.

A method of forming the smooth layer on a surface of a base material is not particularly limited, however, for example, a wet coating method such as a spin coating method, a spraying method, a blade coating method, and a dipping method, and a dry coating method such as a deposition method are preferably applied.

Further, when the smooth layer is formed, as needed, into the above-described photosensitive resin, an additive such as an antioxidant, an ultraviolet absorber, and a plasticizer can be added. In addition, in order to improve the film formation to the formed smooth layer, or to prevent the pinhole generation of the film formed on the smooth layer, appropriate resins and additives may be used.

Further, examples of the solvent that is used when a smooth layer is formed by using a coating liquid in which a photosensitive resin is dissolved or dispersed in a solvent include alcohols such as methanol, ethanol, n-propanol, isopropanol, ethylene glycol, and propylene glycol; terpenes such as α- or β-terpineol; ketones such as acetone, methyl ethyl ketone, cyclohexanone, N-methyl-2-pyrrolidone, diethyl ketone, 2-heptanone, and 4-heptanone; aromatic hydrocarbons such as toluene, xylene, and tetramethylbenzene; glycol ethers such as cellosolve, methyl cellosolve, ethyl cellosolve, carbitol, methyl carbitol, ethyl carbitol, butyl carbitol, propylene glycol monomethyl ether, propylene glycol monoethyl ether, dipropylene glycol monomethyl ether, dipropylene glycol monoethyl ether, triethylene glycol monomethyl ether, and triethylene glycol monoethyl ether; acetic acid esters such as ethyl acetate, butyl acetate, cellosolve acetate, ethyl cellosolve acetate, butyl cellosolve acetate, carbitol acetate, ethyl carbitol acetate, butyl carbitol acetate, propylene glycol monomethyl ether acetate, propylene glycol monoethyl ether acetate, 2-methoxyethyl acetate, cyclohexyl acetate, 2-ethoxyethyl acetate, and 3-methoxy butyl acetate; diethylene glycol dialkyl ether; dipropylene glycol dialkyl ether; 3-ethoxy ethyl propionate; methyl benzoate; N,N-dimethylacetamide; and N,N-dimethylformamide.

In addition, the smoothness of the smooth layer is expressed by a value of the surface roughness defined in JIS B 0601, and the maximum cross-sectional height Rt(p) is preferably 10 nm or more to 30 nm or less. If the Rt is 10 nm or more, in the subsequent stage of the application of a polysilazane-containing coating liquid, when the coating device is brought into contact with the surface of the smooth layer by a coating system of a wire bar, a wireless bar or the like, the stable coating properties can be obtained. Further, if the Rt is 30 nm or less, irregularities that may be generated during the application of a polysilazane-containing coating liquid can be smoothed.

In addition, one of the preferred embodiments of the additive that is added when the smooth layer is formed, is that in a photosensitive resin, a reactive silica particle in which a photosensitive group having photopolymerization reactivity is introduced onto the surface (hereafter, simply also referred to as "reactive silica particle") is contained. Herein, examples of the photosensitive group having photopolymerizability include a polymerizable unsaturated group represented by a (meth) acryloyloxy group, and the like. Further, the photosensitive resin may be a photosensitive resin containing a compound that can perform photopolymerization reaction with the photosensitive group having photopolymerization reactivity that has been introduced onto the surface of the reactive silica particle, for example, an unsaturated organic compound having a polymerizable unsaturated group. In addition, as the photosensitive resin, the one in which the solid content is adjusted by mixing an appropriate diluting solvent for general purposes with an unsaturated organic compound having such a reactive silica particle and a polymerizable unsaturated group can be used.

Herein, the average particle diameter of the reactive silica particles is preferably 0.001 to 0.1 µm. By setting the average particle diameter in the range described above, by using the matting agent consisting of inorganic particles that will be described below in combination, a smooth layer having an optical property that satisfies the anti-glare property and the resolution in well balance, and a hard coat property in combination, is easily formed. In addition, from the viewpoint that such an effect can be more easily obtained, the average particle diameter of the reactive silica particles is more preferably 0.001 to 0.01 µm.

In the present invention, in the smooth layer, the above-described matting agent consisting of inorganic particles is preferably contained at a mass ratio of 20 % by mass or more to 60 % by mass or less. If the content of the matting agent is 20 % by mass or more, the adhesion to the water vapor barrier layer is improved. On the other hand, if the content of the matting agent is 60 % by mass or less, bending of the film can be suppressed, occurrence of the cracks can be prevented when a heating treatment is performed, and optical properties such as the transparency and the refractive index of the water vapor barrier film are not adversely affected.

In addition, in the present invention, the one in which polymerizable unsaturated group-modified hydrolyzable silane is chemically bonded by generating a silyloxy group, with silica particles by the hydrolysis reaction of hydrolyzable silyl group, can be used as a reactive silica particle. Examples of the hydrolyzable silyl group include, for example, a carboxylate silyl group such as an alkoxy silyl group, and an acetoxy silyl group; a halogenated silyl group such as a chlorosilyl group; an aminosilyl group; an oximesilyl group; and a hydride silyl group. Examples of the polymerizable unsaturated group include an acryloyloxy group, a methacryloyloxy group, a vinyl group, a propenyl group, a butadienyl group, a styryl group, an ethynyl group, a cinnamoyl group, a maleate group, and an acrylamide group.

In the present invention, the thickness of smooth layer is preferably 1 to 10 µm, and more preferably 2 to 7 µm. If the thickness is 1 µm or more, the smoothness as the water vapor barrier film having the smooth layer easily becomes sufficient; and if the thickness is 10 µm or less, the balance of the optical properties of the water vapor barrier film can be easily adjusted, and further when the smooth layer is provided only on the one surface of the water vapor barrier film, curl of the water vapor barrier film can be easily suppressed.

### (Bleed-out preventing layer)

In addition, in the base material according to the present invention, a bleed-out preventing layer may be formed.

Ableed-out preventing layer is provided on a surface of the base material provided with a smooth layer, which is opposite to the surface on which the smooth layer is provided, in order to suppress the phenomenon that the surface of the film is contaminated by the migration of unreacted oligomers and the like from the base material provided with the smooth layer when the film is heated. As long as the bleed-out preventing layer has this function, basically the bleed-out preventing layer may have the same constitution as that of the smooth layer.

The bleed-out preventing layer contains an unsaturated organic compound having a polymerizable unsaturated group. Examples of the unsaturated organic compound include a polyvalent unsaturated organic compound having two or more polymerizable unsaturated groups in the molecule, and a monovalent unsaturated organic compound having one polymerizable unsaturated group in the molecule.

As another additive, amatting agentmaybe contained. As the matting agent, inorganic particles having an average particle diameter of around 0.1 to 5 µm are preferable. Examples of such inorganic particles include silica, alumina, talc, clay, calcium carbonate, magnesium carbonate, barium sulfate, aluminum hydroxide, titanium dioxide, and zirconium oxide. These matting agents may be used in one kind alone or in combination of two or more kinds. In addition, the matting agent consisting of inorganic particles can be mixed in a ratio of preferably 2 parts by mass or more, more preferably 4 parts by mass or more, and furthermore preferably 6 parts by mass or more, to preferably 20 parts by mass or less, more preferably 18 parts by mass or less, and furthermore preferably 16 parts by mass or less, relative to 100 parts by mass of the solid content of the hard coat agent.

Further, in the bleed-out preventing layer, as a component other than the hard coat agent and the matting agent, a thermoplastic resin, a thermocurable resin, an ionizing radiation curable resin, and a photopolymerization initiator may be contained.

Examples of the thermoplastic resin include a cellulose derivative such as acetyl cellulose, nitrocellulose, acetylbutyl cellulose, ethyl cellulose, andmethyl cellulose; a vinyl-based resin such as vinyl acetate and a copolymer thereof, vinyl chloride and a copolymer thereof, and vinylidene chloride and a copolymer thereof; an acetal-based resin such as polyvinyl formal, and polyvinyl butyral; an acrylic-based resin such as an acrylic resin and a copolymer thereof, and a methacrylic resin and a copolymer thereof; a polystyrene resin; a polyamide resin; a linear polyester resin; and a polycarbonate resin.

Examples of the thermocurable resin include a thermosetting urethane resin consisting of acrylic polyol and an isocyanate prepolymer, a phenolic resin, a urea-melamine resin, an epoxy resin, an unsaturated polyester resin, and a silicone resin.

As the ionizing radiation curable resin, the one that is cured by the irradiation of an ionizing radiation curing paint in which one kind alone or two or more kinds of photopolymerizable prepolymers, photopolymerizable monomers, and the like are mixed, with ionizing radiation (ultraviolet rays or electron rays), may be used. Herein, as the photopolymerizable prepolymer, an acrylic-based prepolymer that has two or more acryloyl groups in the molecule, and forms a three dimensional network structure by cross-linking curing is particularly preferably used. As such an acrylic-based prepolymer, a urethane acrylate, a polyester acrylate, an epoxy acrylate, a melamine acrylate, and the like may be used. Further, as the photopolymerizable monomer, the polyvalent unsaturated organic compound described above, and the like can be used.

Examples of the photopolymerization initiator include acetophenone, benzophenone, Michler's ketone, benzoin, benzyl methyl ketal, benzoin benzoate, hydroxy cyclohexyl phenyl ketone, 2-methyl-1-(4-(methylthio)phenyl)-2-(4-morpholinyl)-1-pr opane, α-acyloxime ester, and thioxanthones.

The bleedout preventing layer as described above can be formed as follows. A coating liquid is prepared by mixing a hard coat agent, a matting agent, and other components that are added as needed, and adding a predetermined diluting solvent, the prepared coating liquid is applied on a surface of a base material by a conventionally known application method, subsequently, the applied coating liquid is irradiated with ionizing radiation, and cured. In addition, as a method of irradiating with ionizing radiation, a technique of irradiating with the ultraviolet rays in the wavelength range of 100 to 400 nm, preferably 200 to 400 nm, which are emitted from a ultra-high pressure mercury lamp, a high pressure mercury lamp, a low pressure mercury lamp, a carbon arc, a metal halide lamp, or the like; or a technique of irradiating with the electron rays in the wavelength range of 100 nm or less, which are emitted from a scanning type- or a curtain type-electron beam accelerator; may be employed.

The thickness of the bleed-out preventing layer is preferably 1 to 10 µm, and more preferably 2 to 7 µm. If the thickness of the bleed-out preventing layer is 1 µm or more, the heat resistance as the water vapor barrier film easily becomes sufficient; and if the thickness is 10 µm or less, the balance of the optical properties of the water vapor barrier film can be easily adjusted, and further when the smooth layer is provided only on one surface of the water vapor barrier film, curl of the water vapor barrier film can be easily suppressed.

### [Electronic device]

The water vapor barrier film of the present invention can be used as a sealing film sealing an electronic device such as solar cells, a liquid crystal display, and an organic EL element.

An organic EL panel that is an electronic equipment in which the water vapor barrier film is used as a sealing film will be explained briefly, as an example.

The organic EL panel is provided with a water vapor barrier film; transparent electrodes of ITO formed on the water vapor barrier film; an organic EL element formed on the water vapor barrier film via the transparent electrodes; a facing film arranged via an adhesive layer so as to cover the organic EL element; and the like. In addition, it can be said that the transparent electrodes forms part of the organic EL element.

On the surface on which a water vapor barrier layer is formed in the water vapor barrier film, transparent electrodes and an organic EL element are to be formed.

Further, as the facing film, in addition to a metal film such as aluminum foil, a water vapor barrier film of the present invention may be used. In the case where a water vapor barrier film is used as the facing film, the surface on which the water vapor barrier layer is formed may be faced to the organic EL element, and affixed by an adhesive layer.

### EXAMPLES

Hereinafter, the present invention will be specifically described by way of Examples, however, the present invention is not limited thereto. In addition, the expression of "parts" or "%" used in Examples means "parts by mass" or "% by mass", respectively, unless otherwise noted.

### Example 1

### <<Preparation of base material>>

### [Preparation of base material (A)]

As a thermoplastic resin base material (base material), by using a polyester film (super low heat shrinkage PET Q83, manufactured by Teijin DuPont Films Japan Limited) having a thickness of 125 µm, both surfaces of which are subjected to an easy adhesion treatment, a bleed-out preventing layer 1 was formed on one surface of the base material, and a smooth layer 1 was formed on the other surface of the base material, and thus a base material (A) was prepared. A bleed-out preventing layer 1 and a smooth layer 1 were formed as follows. In addition, PET is an abbreviation for polyethylene terephthalate.

### <Formation of bleed-out preventing layer 1>

On one surface of the above-described thermoplastic resin base material, a UV curable organic / inorganic hybrid hard coat material OPSTAR Z7535 manufactured by JSR Corporation was applied so that the film thickness of the bleed-out preventing layer is 4.0 µm, then the applied hard coat material was subjected to a curing treatment by using a high pressure mercury lamp, in an air atmosphere with an irradiation energy amount of 1.0 J/cm², under a drying conditions of 80°C for 3 minutes, and thus the bleed-out preventing layer was formed.

### <Formation of smooth layer 1>

On a surface opposite to the surface on which the bleed-out preventing layer 1 of the above-described thermoplastic resin base material was formed, a UV curable organic / inorganic hybrid hard coat material OPSTAR Z7501 manufactured by JSR Corporation was applied so that the film thickness of the smooth layer is 4.0 µm, and then the applied hard coat material was dried at 80°C for 3 minutes. Next, the dried hard coat material was irradiated with an irradiation energy amount of 1.0 J/cm² in an air atmosphere by using a high pressure mercury lamp, and cured, and thus a smooth layer 1 was formed.

The surface roughness Rz on the surface of the smooth layer 1 formed by the above-described method was around 25 nm as measured in accordance to the method defined by JIS B 0601. At this time, the surface roughness was measured by using an AFM (atomic force microscope), SPI3800N DFM manufactured by Seiko Instruments Inc. The range per one measurement was set to 80 µm × 80 µm, and the measurement was performed three times at different measurement points, and the average of the Rz values that were obtained by each measurement was set to the measured value.

Further, the linear expansion coefficient of the base material (A) prepared in the above was 65 ppm/°C. At this time, the linear expansion coefficient was measured as follows. More specifically, by using a thermal stress-strain measuring device, EXSTAR TMA/SS6000 type manufactured by Seiko Instruments Inc., the temperature of a base material (A) to be measured was increased from 30°C to 50°C at a rate of 5°C per minute under a nitrogen atmosphere, and then held once, was increased again at a rate of 5°C per minute, and at 30 to 150°C, the linear expansion coefficient was measured and determined.

### [Preparation of base material (B)]

As a heat resistant base material, by using a transparent polyimide-based film (Neopulim L, manufactured by Mitsubishi Gas Chemical Company, Inc.) having a thickness of 200 µm, both surfaces of which are subjected to an easy adhesion treatment, smooth layers 2 and 3 were formed on both surfaces of the base material, and thus a base material (B) was prepared. Smooth layers 2 and 3 were formed as follows.

### <Formation of smooth layer 2>

8.0 g of trimethylolpropane triglycidyl ether (EPOLIGHT 100MF, manufactured by KYOEISHA CHEMICAL Co.,LTD) 5.0 g of ethylene glycol diglycidyl ether (EPOLIGHT 40E, manufactured by KYOEISHA CHEMICAL Co.,LTD), 12.0 g of silsesquioxane having an oxetanyl group, OX-SQ-H (manufactured by TOAGOSEI CO., LTD.), 32.5 g of 3-glycidoxypropyltrimethoxysilane, 2.2 g of Al(III) acetylacetonate, 134.0 g of methanol silica sol (solid content concentration: 30 % by mass, manufactured by Nissan Chemical Industries, Ltd.), 0.1 g of BYK333 (a silicone-based surfactant, manufactured by BYK Japan KK), 125.0 g of butyl cellosolve, and 15.0 g of 0.1 mol/L hydrochloric acid aqueous solution, were mixed and thoroughly stirred. The mixture was further allowed to stand and degassed at room temperature to preparer a smooth layer coating liquid.

One surface of the heat resistant base material was subjected to a corona discharge treatment by a conventional method, then the above-prepared smooth layer coating liquid was applied so that the film thickness of the smooth layer is 4.0 µm, and then the applied coating liquid was dried at 80°C for 3 minutes. Further, the dried coating liquid was subjected to a heating treatment at 120°C for 10 minutes to form a smooth layer 2.

### <Formation of smooth layer 3>

On a surface opposite to the surface on which the smooth layer 2 of the above-described heat resistant base material was formed, a smooth layer 3 was formed by using the same method as that of the smooth layer 2.

The surface roughness of each of the formed smooth layer 2 and smooth layer 3 of base material (B) was measured by using the same method as that in the description of base material (A), all the surface roughness Rz values were around 20 nm.

Further, the linear expansion coefficient of the base material (B) prepared in the above was measured by using the same method as that in the description of base material (A), the linear expansion coefficient was 40 ppm/°C.

### [Preparation of base material (C)]

Except that as a heat resistant base material, Silplus H100 having a thickness of 100 µm manufactured by Nippon Steel Chemical Co.,Ltd., which is a film in which silsesquioxane having an organic-inorganic hybrid structure is used as a basic skeleton, was used, a base material (C) was prepared by using the same method as that of base material (B). In addition, the surface roughness of each of the smooth layer 2 and smooth layer 3 of base material (C) was measured by using the same method as that in the description of base material (A), all the surface roughness Rz values were around 20 nm.

Further, the linear expansion coefficient of the prepared base material (C) prepared in the above was measured by using the same method as that in the description of base material (A), the linear expansion coefficient was 80 ppm/°C.

### <<Preparation of water vapor barrier film>>

### [Preparation of water vapor barrier film 1: formation of water vapor barrier layer by deposition method (Comparative example)]

By using a vacuum plasma CVD apparatus, a water vapor barrier layer 1 was formed on a surface of the smooth layer 1 of the base material (A). At this time, a high frequency power source of 27.12 MHz was used, and the distance between electrodes was set to 20 mm. Silane gas at a flow rate of 7.5 sccm, ammonia gas at a flow rate of 50 sccm, and hydrogen gas at a flow rate of 200 sccm, which are raw material gases, were introduced into a vacuum chamber. Next, at the start of film formation, the temperature of the substrate (A) was set to 100°C, and the gas pressure during the film formation was set to 30 Pa, a water vapor barrier layer 1 having a film thickness of 100 nm, in which silicon nitride was used as the main component, was formed, and thus a water vapor barrier film 1 was obtained.

### [Preparation of water vapor barrier film 2: formation of water vapor barrier layer by deposition method (Comparative example)]

Except that silane gas at a flow rate of 7.5 sccm, ammonia gas at a flow rate of 100 sccm, and nitrous oxide gas at a flow rate of 50 sccm, which are raw material gases, were introduced into a vacuum chamber, then at the start of film formation, the temperature of the substrate (B) was set to 100°C, and the gas pressure during the film formation was set to 100 Pa, a water vapor barrier layer 2 having a film thickness of 200 nm, in which silicon nitride oxide was used as the main component, was formed; by using the same method as that of the above-described water vapor barrier film 1, a water vapor barrier film 2 was prepared.

[Preparation of water vapor barrier film 3: formation of water vapor barrier layer by deposition method

### (Comparative example)]

Except for using a base material (A), a water vapor barrier film 3 having a water vapor barrier layer 3 was prepared by using the same method as that of the above-described water vapor barrier film 2.

### [Preparation of water vapor barrier film 4: vacuum ultraviolet irradiation method (the present invention)]

### <Formation of water vapor barrier layer 4>

### (Formation of polysilazane layer (coated film))

On the base material (B), a polysilazane-containing coating liquid 4 showing below was applied by using a spin coater so that the film thickness of the water vapor barrier layer is 20 nm, and the applied coating liquid was dried, and thus a polysilazane layer was formed. The drying was performed at 100°C for 2 minutes.

### <Preparation of polysilazane-containing coating liquid 4>

By using a mixture of a dibutyl ether solution containing 20 % by mass of catalyst-free perhydropolysilazane (AQUAMICA NN120-20 manufactured by AZ Electronic Materials) and a dibutyl ether solution containing 20 % by mass of perhydropolysilazane in which an amine catalyst was contained in an amount of 5 % by mass in terms of solid content (AQUAMICA NAX120-20 manufactured by AZ Electronic Materials), an amine catalyst was adjusted to be 1 % by mass in terms of solid content, then the resultant mixture was diluted with dibutyl ether, and thus a polysilazane-containing coating liquid 4 was prepared as a dibutyl ether solution having a total solid content of 2 % by mass.

### (Vacuum ultraviolet irradiation treatment)

The polysilazane layer formed above was dried at 100°C for 2 minutes, then the dried polysilazane layer was subj ected to an excimer modification treatment (vacuum ultraviolet irradiation treatment) by the following device and the following conditions to modify the polysilazane, and thus a water vapor barrier layer 4 that is a polysilazane modified layer was formed. The modification treatment was performed at a dew-point temperature of -20°C.

### <Vacuum ultraviolet irradiation device>

1) Vacuum ultraviolet irradiation device: an excimer irradiation device MODEL: MECL-M-1-200 manufactured by M.D.COM.inc.
2) Irradiation ultraviolet wavelength: 172 nm
3) Lamp enclosure gas: Xe

### <Modification treatment condition>

1) Excimer light intensity: 130 mW/cm² (172 nm)
2) Distance between sample and light source: 2 mm
3) Stage heating temperature: 95°C
4) Oxygen concentration in irradiation device: 0.3%
5) Velocity of stage conveyance at excimer light irradiation: 10 mm/sec
6) Number of stage conveyances at excimer light irradiation: 6 round trips

Energy with which irradiated to the surface of the sample application layer in the vacuum ultraviolet irradiation step was measured by using an ultraviolet accumulated actinometer manufactured by Hamamatsu Photonics K.K: C8026/H8025 UV POWER METER, and using a sensor head with 172 nm. Based on the irradiation energy obtained by this measurement, the moving velocity of sample stage was adjusted so that the accumulated light amount is 3000 mJ/cm². In addition, vacuum ultraviolet irradiation was performed in the same manner as in the measurement of irradiation energy, after the aging for 10 minutes.

### <Formation of protective layer 4>

### (Formation of polysiloxane layer (coated film))

On the above-described water vapor barrier layer 4, the following polysiloxane-containing coating liquid 4 was applied by a spin coater so that the film thickness of a protective layer is 1000 nm, then the applied coating liquid was dried, and thus a polysiloxane layer was formed. The drying conditions were 120°C and for 20 minutes.

### <Preparation of coating liquid 4 for formation of protective layer>

50 parts of silanol-terminated polydimethylsiloxane having a MW of 3500 as hydroxy group-containing polysiloxane (A1) (product name: YF-3800, manufactured by GE Toshiba Silicone Co., Ltd.), 50 parts of alkoxy-terminated silicon polymer having a MW of 2,000 as an alkoxy group-containing siloxane polymer (B1) (product name: X40-9225, manufactured by Shin-Etsu Chemical Co., Ltd.), 0.6 part of sodiummethoxide diluted 500 times with propylene glycol monopropyl ether as a condensation catalyst, and 66 part of methyl isobutyl ketone as an organic solvent, were added, and the resultant mixture was subjected to dealcoholization at 60°C for 4 hours. Next, 6 parts of γ-glycidoxypropyltrimethoxysilane was added, and the resultant mixture was subjected to capping reaction of silanol groups at 60°C for 2 hours, and thus a coating liquid (polysiloxane-containing coating liquid) 4 containing siloxane-based condensation product having a solid content concentration of around 55 % by mass was prepared. In addition, the weight average molecular weight of the obtained siloxane-based condensation product was 5,000.

### (Vacuum ultraviolet irradiation treatment)

Except that the accumulated light amount of the vacuum ultraviolet rays was changed to 1000 mJ/cm², by using the same method as that of the vacuum ultraviolet light irradiation in the formation of the water vapor barrier layer 4, the polysiloxane layer formed above was subjected to a vacuum ultraviolet irradiation treatment to modify the polysiloxane, and thus a protective layer 4 that is a polysiloxane modified layer was formed.

### [Preparation of water vapor barrier films 5 to 25: vacuum ultraviolet irradiation method (the present invention)]

Except that the kind of base material, the film thickness of water vapor barrier layer in the formation of water vapor barrier layer 4, the drying temperature (drying time is 2 minutes), and the irradiation energy amount of vacuum ultraviolet rays during the polysilazane layer modification; and the film thickness of protective layer in the formation of protective layer 4, the drying temperature (drying time is 20 minutes), and the irradiation energy amount of vacuum ultraviolet rays during the polysiloxane layer modification, were changed to the conditions described in Table 1, respectively, by using the same method as that of the preparation of the water vapor barrier film 4, water vapor barrier films 5 to 25 were prepared.

### [Preparation of water vapor barrier film 26: vacuum ultraviolet irradiation method (the present invention)]

In the above-described water vapor barrier film 6, except that the polysiloxane-containing coating liquid 26 prepared in the following was used for the formation of a protective layer, by using the same method as that of the water vapor barrier film 6, a water vapor barrier film 26 was prepared.

### <Preparation of polysiloxane-containing coating liquid 26>

"GLASCA HPC 7003" and "GLASCA HPC 404H", manufactured by JSR Corporation, were mixed at a ratio of 10:1. Next, this mixture was diluted 2 times with butanol, further 5.0% of butyl cellosolve was added to the diluted mixture, and thus a polysiloxane-containing coating liquid 26 was prepared. The solid content of the polysiloxane-containing coating liquid 26 was 10%.

### [Preparation of water vapor barrier film 27: vacuum ultraviolet irradiation method (the present invention)]

Except that the polysiloxane-containing coating liquid 27 prepared in the following was used for the formation of a protective layer, a water vapor barrier film 27 was prepared by using the same method as that of the water vapor barrier film 6.

### <Preparation of polysiloxane-containing coating liquid 27>

"TSF84" manufactured by Momentive Performance Materials Inc. was diluted 2 times with butanol, further 5.0% of butyl cellosolve was added to the diluted mixture, and thus a polysiloxane-containing coating liquid 27 was prepared. The solid content of the polysiloxane-containing coating liquid 27 was 10%.

### [Preparation of water vapor barrier film 28: vacuum ultraviolet irradiation method (the present invention)]

Except that the polysiloxane-containing coating liquid 28 prepared in the following was used for the formation of a protective layer, a water vapor barrier film 28 was prepared by using the same method as that of the water vapor barrier film 6.

### <Preparation of polysiloxane-containing coating liquid 28>

"X-40-9238" manufactured by Shin-Etsu silicone Co.,Ltd. was diluted 6 times with butanol, further 5.0% of butyl cellosolve was added to the diluted mixture, and thus a polysiloxane-containing coating liquid 28 was prepared. The solid content of polysiloxane-containing coating liquid 28 was 10%.

### [Preparation of water vapor barrier film 29: protective layer, sol-gel method formation (Comparative example)]

Except that the protective layer was formed by using the coating liquid 29 prepared in the following by a sol-gel method, a water vapor barrier film 29 was prepared by using the same method as that of the water vapor barrier film 6. In addition, the formation of a protective layer by a sol-gel method was performed as follows. That is, the above-described coating liquid was applied on a water vapor barrier layer so that the film thickness of a protective layer is 1000 nm, then the obtained coated film was dried at 120°C, and thus a protective layer was formed.

### (Preparation of coating liquid 29)

Into a mixed solution of 5 g of 25% ammonia aqueous solution, 320 g of ultrapure water, and 600 g of ethanol, 15 g (7.4 g in terms of complete hydrolysis condensate) of methyl trimethoxysilane and 20 g (5.8 g in terms of complete hydrolysis condensate) of tetraethoxysilane were added, then the resultant mixture was reacted at 60°C for 3 hours, and then into the resultant mixture, maleic acid was added so that the pH of the mixture is 2.5. Next, in this resultant mixture, 150 g of propylene glycol monopropyl ether was added, and then the resultant mixture was concentrated under reduced pressure to prepare a coating liquid 29 having a solid content of 6%.

**[Table 1]**

| Water vapor barrier film Number | Base material | | Water vapor barrier layer | | | | Protective layer | | | | Remarks |
|---|---|---|---|---|---|---|---|---|---|---|---|
| | Base material Number | Linear expansion coefficient (ppm/°C) | Coating liquid Number | Film thickness (nm) | Drying temperature (°C) | Accumulated light amount of vacuum ultraviolet rays (mJ/cm²) | Coating liquid Number | Film thickness (nm) | Drying temperature (°C) | Accumulated light amount of vacuum ultraviolet rays (mJ/cm²) | |
| 1 | (B) | 40 | - | 100 | - | Film formation by vacuum deposition method | - | - | - | - | Comparative example |
| 2 | (B) | 40 | - | 200 | - | Film formation by vacuum deposition method | - | - | - | - | Comparative example |
| 3 | (A) | 65 | - | 200 | - | Film formation by vacuum deposition method | - | - | - | - | Comparative example |
| 4 | (B) | 40 | 4 | 20 | 100 | 3000 | 4 | 1000 | 120 | 1000 | The present invention |
| 5 | (B) | 40 | 4 | 100 | 100 | 3000 | 4 | 1000 | 120 | 1000 | The present invention |
| 6 | (B) | 40 | 4 | 200 | 100 | 3000 | 4 | 1000 | 120 | 1000 | The present invention |
| 7 | (B) | 40 | 4 | 500 | 100 | 3000 | 4 | 1000 | 120 | 1000 | The present invention |
| 8 | (B) | 40 | 4 | 1500 | 100 | 3000 | 4 | 1000 | 120 | 1000 | The present invention |
| 9 | (B) | 40 | 4 | 200 | 100 | 500 | 4 | 1000 | 120 | 1000 | The present invention |
| 10 | (B) | 40 | 4 | 200 | 100 | 1500 | 4 | 1000 | 120 | 1000 | The present invention |
| 11 | (B) | 40 | 4 | 200 | 100 | 5000 | 4 | 1000 | 120 | 1000 | The present invention |
| 12 | (B) | 40 | 4 | 200 | 100 | 12000 | 4 | 1000 | 120 | 1000 | The present invention |
| 13 | (B) | 40 | 4 | 200 | 40 | 3000 | 4 | 1000 | 120 | 1000 | The present invention |
| 14 | (B) | 40 | 4 | 200 | 300 | 3000 | 4 | 1000 | 120 | 1000 | The present invention |
| 15 | (B) | 40 | 4 | 200 | 100 | 3000 | 4 | 60 | 120 | 1000 | The present invention |
| 16 | (B) | 40 | 4 | 200 | 100 | 3000 | 4 | 300 | 120 | 1000 | The present invention |
| 17 | (B) | 40 | 4 | 200 | 100 | 3000 | 4 | 2000 | 120 | 1000 | The present invention |
| 18 | (B) | 40 | 4 | 200 | 100 | 3000 | 4 | 12000 | 120 | 1000 | The present invention |
| 19 | (B) | 40 | 4 | 200 | 100 | 3000 | 4 | 1000 | 120 | 300 | The present invention |
| 20 | (B) | 40 | 4 | 200 | 100 | 3000 | 4 | 1000 | 120 | 3000 | The present invention |
| 21 | (B) | 40 | 4 | 200 | 100 | 3000 | 4 | 1000 | 120 | 12000 | The present invention |
| 22 | (B) | 40 | 4 | 200 | 100 | 3000 | 4 | 1000 | 40 | 1000 | The present invention |
| 23 | (B) | 40 | 4 | 200 | 100 | 3000 | 4 | 1000 | 300 | 1000 | The present invention |
| 24 | (A) | 65 | 4 | 200 | 100 | 3000 | 4 | 1000 | 120 | 1000 | The present invention |
| 25 | (C) | 80 | 4 | 200 | 100 | 3000 | 4 | 1000 | 120 | 1000 | The present invention |
| 26 | (B) | 40 | 4 | 200 | 100 | 3000 | 26 | 1000 | 120 | 1000 | The present invention |
| 27 | (B) | 40 | 4 | 200 | 100 | 3000 | 27 | 1000 | 120 | 1000 | The present invention |
| 28 | (B) | 40 | 4 | 200 | 100 | 3000 | 28 | 1000 | 120 | 1000 | The present invention |
| 29 | (B) | 40 | 4 | 200 | 100 | 3000 | 29 | 1000 | 120 | Film formation by sol-gel method | Comparative example |

### «Evaluation of water vapor barrier film»

### [Performance evaluation of untreated sample]

### (Evaluation of water vapor barrier property 1)

### <Apparatus for evaluation of water vapor barrier property>

Deposition apparatus: a vacuum deposition apparatus, JEE-400 manufactured by JEOL Ltd.
Constant temperature and humidity oven: Yamato Humidic Chamber IG47M

### <Raw materials used for evaluation>

Metal corroded by reacting with water: calcium (granular)
Water vapor impermeable metal: aluminum (average φ: 4 mm, granular)

### <Preparation of sample for water vapor barrier property evaluation>

By using a vacuum deposition apparatus (a vacuum deposition apparatus, JEE-400 manufactured by JEOL Ltd.), on the surface on which a water vapor barrier layer of each of the water vapor barrier films prepared above, metal calcium was deposited in a size of 12 mm × 12 mm via a mask.

Thereafter, the mask was removed while remaining in the vacuum state, aluminum was deposited on the whole surface on one side of a sheet to temporarily seal the surface. Subsequently, the vacuum state was released, the resultant sheet was promptly transferred into a dry nitrogen gas atmosphere, quartz glass having a thickness of 0.2 mm was bonded on the deposited aluminum surface via an ultraviolet curable resin for sealing (manufactured by Nagase ChemteX Corporation), the resultant sheet was irradiated with ultraviolet rays, and cured and bonded to seal completely the surface, and thus each of samples for water vapor barrier property evaluation was prepared.

### <Evaluation of water vapor barrier property>

Each of the obtained samples for water vapor barrier property evaluation was stored at high temperature and high humidity environment of 85°C and 90%RH for 60 hours, then the area where the metal calcium had corroded was determined with the expression of % to the area with a size of 12 mm × 12 mm where the metal calcium had deposited, and thus water vapor barrier property 1 was evaluated in accordance with the following criteria.
○: the area where the metal calcium had corroded was less than 1.0% of the total area.
Δ: the area where the metal calcium had corroded was 1.0% or more to less than 5.0% of the total area.
×: the area where the metal calcium had corroded was 5.0% or more of the total area.

### (Evaluation of transparency 1)

As to each of the water vapor barrier films, the transparency 1 was evaluated in accordance with the following criteria by measuring the average transmittance in the visible light region in accordance with ASTM D-1003 standard by using a spectrophotometer (an ultraviolet visible spectrophotometer, UV-2500PC manufactured by Shimadzu Corporation). In addition, the visible light region has a wavelength 400 to 720 nm.
○: the average transmittance in the visible light region was 90% or more.
Δ: the average transmittance in the visible light region was 85% or more to less than 90%.
×: the average transmittance in the visible light region was less than 85%.

### (Evaluation of smoothness 1)

As to each of the water vapor barrier films, the smoothness 1 was evaluated in accordance with the following criteria by performing the visual inspection evaluation of the presence or absence of base material deformation and the smoothness.
○: the smoothness on the surface of water vapor barrier film was high, and the deformation of the base material and the like were not observed at all.
Δ: extremely weak disturbance of the smoothness on the surface of water vapor barrier film, and the deformation of the base material and the like were observed, however, the quality is acceptable for practical use.
×: Obvious disturbance of the smoothness on the surface of water vapor barrier film, and the deformation of the base material and the like were observed, and the quality is problematic in practical use.

### [Performance evaluation of heating and water immersion treatment sample: evaluation of water resistance]

Each of the water vapor barrier films was introduced into a constant temperature dryer at 100°C for 24 hours, and then immersed in pure water at 25°C for 24 hours. Further, subsequently the resultant water vapor barrier film was introduced into a constant temperature dryer at 100°C for 24 hours, and then subjected to heating and water immersion treatment.

### (Evaluation of water vapor barrier property 2, transparency 2, and smoothness 2)

As to each of the above-described water vapor barrier films to which heating and water immersion treatment had been performed, the water vapor barrier property 2, the transparency 2, and the smoothness 2 were performed by using the same method as that of the water vapor barrier property 1, the transparency 1, and the smoothness 1 in the performance evaluation of untreated sample.

### [Evaluation of high temperature heating treatment sample: evaluation of heat resistance]

Each of the water vapor barrier films was subjected to the high temperature heating treatment in a constant temperature dryer at 200°C in the atmosphere for 10 minutes.

### (Evaluation of water vapor barrier property 3, transparency 3, and smoothness 3)

As to each of the above-described water vapor barrier films to which high temperature heating treatment had been performed, the water vapor barrier property 3, the transparency 3, and the smoothness 3 were performed by using the same method as that of the water vapor barrier property 1, the transparency 1, and the smoothness 1 in the performance evaluation of untreated sample.

The results obtained in the above are shown in Table 2.

**[Table 2]**

| Water vapor barrier film, Number | Untreated sample | | | Heating and water immersion treatment (Water resistance) | | | High temperature heating treatment (Heat resistance) | | | Remarks |
|---|---|---|---|---|---|---|---|---|---|---|
| | Water vapor barrier property 1 | Transparency 1 | Smoothness 1 | Water vapor barrier property 2 | Transparency 2 | Smoothness 2 | Water vapor barrier property 3 | Transparency 3 | Smoothness 3 | |
| 1 | Δ | ○ | ○ | × | ○ | ○ | × | ○ | ○ | Comparative example |
| 2 | Δ | ○ | ○ | × | Δ | ○ | × | Δ | × | Comparative example |
| 3 | Δ | ○ | ○ | × | Δ | ○ | × | Δ | × | Comparative example |
| 4 | ○ | ○ | ○ | Δ | ○ | ○ | ○ | ○ | ○ | The present invention |
| 5 | ○ | ○ | ○ | ○ | ○ | ○ | ○ | ○ | ○ | The present invention |
| 6 | ○ | ○ | ○ | ○ | ○ | ○ | ○ | ○ | ○ | The present invention |
| 7 | ○ | ○ | ○ | ○ | ○ | ○ | ○ | ○ | ○ | The present invention |
| 8 | ○ | ○ | ○ | ○ | Δ | ○ | ○ | Δ | Δ | The present invention |
| 9 | ○ | ○ | ○ | Δ | ○ | ○ | ○ | ○ | ○ | The present invention |
| 10 | ○ | ○ | ○ | ○ | ○ | ○ | ○ | ○ | ○ | The present invention |
| 11 | ○ | ○ | ○ | ○ | ○ | ○ | ○ | ○ | ○ | The present invention |
| 12 | ○ | ○ | Δ | ○ | ○ | Δ | ○ | ○ | Δ | The present invention |
| 13 | ○ | ○ | ○ | Δ | ○ | ○ | ○ | ○ | ○ | The present invention |
| 14 | ○ | ○ | ○ | ○ | ○ | Δ | ○ | ○ | Δ | The present invention |
| 15 | ○ | ○ | ○ | Δ | ○ | ○ | Δ | ○ | ○ | The present invention |
| 16 | ○ | ○ | ○ | ○ | ○ | ○ | ○ | ○ | ○ | The present invention |
| 17 | ○ | ○ | ○ | ○ | ○ | ○ | ○ | ○ | O | The present invention |
| 18 | ○ | ○ | ○ | ○ | Δ | ○ | ○ | Δ | Δ | The present invention |
| 19 | ○ | ○ | ○ | Δ | ○ | ○ | Δ | ○ | ○ | The present invention |
| 20 | ○ | ○ | ○ | ○ | ○ | ○ | ○ | ○ | ○ | The present invention |
| 21 | ○ | ○ | Δ | ○ | ○ | Δ | ○ | ○ | Δ | The present invention |
| 22 | ○ | ○ | ○ | Δ | ○ | ○ | ○ | ○ | ○ | The present invention |
| 23 | ○ | ○ | Δ | ○ | ○ | Δ | ○ | ○ | Δ | The present invention |
| 24 | ○ | ○ | ○ | ○ | ○ | ○ | ○ | ○ | Δ | The present invention |
| 25 | ○ | ○ | ○ | ○ | ○ | ○ | ○ | ○ | Δ | The present invention |
| 26 | ○ | ○ | ○ | ○ | ○ | ○ | ○ | ○ | ○ | The present invention |
| 27 | ○ | ○ | ○ | ○ | ○ | ○ | ○ | ○ | ○ | The present invention |
| 28 | ○ | ○ | ○ | ○ | ○ | ○ | ○ | ○ | ○ | The present invention |
| 29 | Δ | ○ | ○ | × | Δ | × | ○ | ○ | Δ | Comparative example |

As is obvious form the results described in Table 2, it is understood that the water vapor barrier film of the present invention, which contains the water vapor barrier layer and protective layer that were formed by forming a coated film by a wet coating method, and then by modifying the formed coated film with the irradiation with vacuum ultraviolet light, maintains the transparency and the smoothness, and further is excellent in the water vapor barrier property, as compared to the comparison sample in which the water vapor barrier layer was prepared by a vacuum deposition method. Further, it is understood that the water vapor barrier film of the present invention maintains excellent water vapor barrier property, transparency, and smoothness, as compared to the comparison sample, even after the heating and water immersion treatment, or the high temperature heating treatment was performed.

### Example 2

### <<Preparation of organic EL element>>

By using each of the water vapor barrier films prepared in Example 1 as a sealing film, organic EL elements 1 to 29 were prepared as an example of an electronic device, in accordance with the following method.

### [Formation of transparent conductive film]

On each of the water vapor barrier layers of each of the water vapor barrier films prepared in Example 1, a transparent conductive film was prepared in accordance with the following method.

By using an apparatus of parallel plate type electrodes as a plasma discharge device, each of the above-described water vapor barrier films was placed between the electrodes, to which mixed gas was introduced so as to form a thin film. In addition, as an earth (ground) electrode, an electrode that was obtained by coating an alumina sprayed film that has high density and high adhesion, on a stainless steel plate of 200 mm × 200 mm × 2 mm, then by applying a solution in which tetramethoxysilane had been diluted with ethyl acetate and drying the applied solution, then by curing the dried resultant with ultraviolet irradiation so as to perform a sealing treatment, by polishing and smoothing the surface of the dielectric that was coated in this manner, and by processing the resultant so that Rmax is 5 µm, was used. Further, as an application electrode, an electrode that was obtained by coating dielectric material to a hollow square pure titanium pipe under the same conditions as those of the earth electrode. Multiple electrodes of the application electrode were prepared, and were provided so as to be opposed to the earth electrode to form a discharge space. In addition, by using a high frequency power source, CF-5000-13M manufactured by PEARL KOGYO Co.,Ltd. as a power source used in plasma generation, electric power at a frequency of 13.56 MHz and 5 W/cm² was supplied.

Further, a mixed gas of the following composition was filled between electrodes so as to be in a plasma state, the surface of the above-described water vapor barrier film was subjected to an atmospheric pressure plasma treatment, a tin-doped indium oxide (ITO) film was formed in a thickness of 100 nm on each of the water vapor barrier layers, and thus samples 1 to 29 in which a transparent conductive film had been formed were obtained.
Discharge gas: helium, 98.5 % by volume
Reactive gas 1: oxygen, 0.25 % by volume
Reactive gas 2: indium acetylacetonate, 1.2 % by volume
Reactive gas 3: dibutyltin diacetate, 0.05 % by volume

### [Preparation of organic EL element]

100 mm × 100 mm of each of samples 1 to 29 in which the obtained transparent conductive film had been formed was used as a substrate, to which patterning was performed, and then a water vapor barrier film substrate in which this ITO transparent electrode had been provided was subjected to ultrasonic cleaning with isopropyl alcohol, and the resultant substrate was dried with dry nitrogen gas. This transparent supporting substrate was fixed to a substrate holder of a vacuum deposition apparatus that is commercially available, on the other hand, 200 mg of α-NPD was placed in a resistive heating molybdenum boat, 200 mg of CBP was placed as a host compound in another resistive heating molybdenum boat, 200 mg of bathocuproine (BCP) was placed in another resistive heating molybdenum boat, 100 mg of Ir-1 was placed in another resistive heating molybdenum boat, and 200 mg of Alq₃ was placed in another resistive heating molybdenum boat, and then these were fixed in the vacuum deposition apparatus.

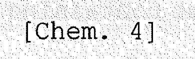

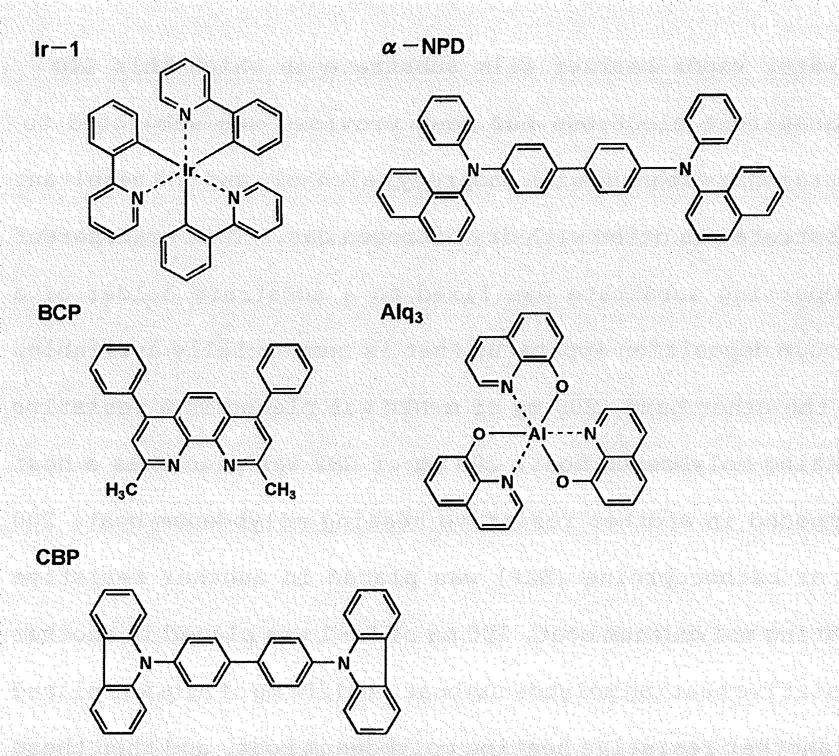

### (Formation of hole transport layer)

Next, the pressure in the vacuum chamber was reduced to 4 × 10⁻⁴ Pa, then the above-described heating boat containing α-NPD was energized and heated, and then a transparent supporting substrate was deposited at a deposition rate of 0.1 nm/sec to form a hole transport layer.

### (Formation of light emitting layer)

Next, the above-described heating boat containing CBP and Ir-1 was energized and heated, and then a hole transport layer was co-deposited at a deposition rate of 0.2 nm/sec, and 0.012 nm/sec, respectively to form a light emitting layer. In addition, the substrate temperature during the deposition was room temperature.

### (Formation of hole blocking layer)

Further, the above-described heating boat containing BCP was energized and heated, and then the above-described light emitting layer was deposited at a deposition rate of 0.1 nm/sec to form a hole blocking layer having a film thickness of 10 nm.

### (Formation of electron transporting layer)

Thereon, furthermore, the above-described heating boat containing Alq₃ was energized and heated, and then the hole blocking layer was deposited at a deposition rate of 0.1 nm/sec to form an electron transporting layer having a film thickness of 40 nm. In addition, the substrate temperature during the deposition was room temperature.

### (Formation of cathode)

Subsequently, 0.5 nm of lithium fluoride and 110 nm of aluminum were deposited to form a cathode, and organic EL elements 1 to 29 using samples 1 to 29, each of which contains a transparent conductive film, were prepared.

### (Sealing of organic EL element)

In an environment that was purged with nitrogen gas (inert gas), an aluminum deposited surface of organic EL element samples 1 to 29, and aluminum foil having a thickness of 100 µm were adhered and sealed by using an epoxy-based adhesive manufactured by Nagase ChemteX Corporation so that the aluminum deposited surface and the aluminum foil are opposed to each other.

### <<Evaluation of organic EL element: evaluation of dark spot resistance, and brightness unevenness resistance>>

The sealed organic EL element samples 1 to 29 were energized in an environment of 40°C and 90%RH, and the changes of the situation of generation and the like of dark spot, and brightness unevenness were observed from day 0 up to day 120, as a result, it was confirmed that the organic EL element prepared by using the water vapor barrier film of the present invention is excellent in the dark spot resistance, and the brightness unevenness resistance, as compared to the Comparative example.

### Reference Signs List

1. Water vapor barrier film
2. Base material
3. Auxiliary layer
4. Water vapor barrier layer
5. Protective layer

## Claims

1. A water vapor barrier film, containing:
at least one water vapor barrier layer, and at least one protective layer, on a base material having gas permeability,
wherein, the water vapor barrier layer is a layer formed by applying a coating liquid containing polysilazane, drying the applied coating liquid to form a film, and then by irradiating the film with vacuum ultraviolet light, and
the protective layer is a layer formed by applying a coating liquid containing polysiloxane, drying the applied coating liquid to form a film, and then by irradiating the film with vacuum ultraviolet light.

2. The water vapor barrier film according to Claim 1, wherein the polysiloxane is a compound represented by the following general formula (a), 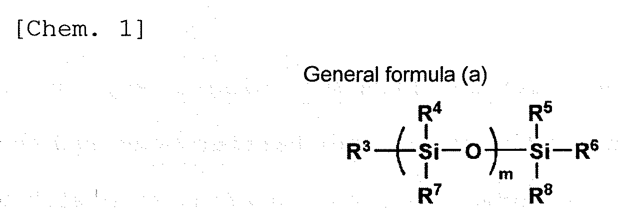 wherein, each of R³ to R⁸ represents an organic group having 1 to 8 carbon atoms, each of which is the same as or different from each other. Herein, each of the R³ to R⁸ contains any of an alkoxy group and a hydroxyl group. m is 1 or more; and a weight average molecular weight is 1000 or more to 20000 or less in terms of polystyrene.

3. The water vapor barrier film according to Claim 1 or 2, wherein a film thickness of the water vapor barrier layer is 50 nm or more to 1.0 µm or less, and a film thickness of the protective layer is 100 nm or more to 10 µm or less.

4. The water vapor barrier film according to any one of Claims 1 to 3, wherein an accumulated light amount of the vacuum ultraviolet light used for a formation of the water vapor barrier layer is 1000 mJ/cm² or more to 10,000 mJ/cm² or less, and an accumulated light amount of the vacuum ultraviolet light used for a formation of the protective layer is 500 mJ/cm² or more to 10,000 mJ/cm² or less.

5. The water vapor barrier film according to any one of Claims 1 to 4, wherein the water vapor barrier layer and the protective layer are formed through a heating step with a heating temperature of 50°C or more to 200°C or less.

6. The water vapor barrier film according to any one of Claims 1 to 5, wherein the base material has a linear expansion coefficient of 50 ppm/°C or less and a total light transmittance of 90% or more.

7. A method for producing a water vapor barrier film, containing:
forming a water vapor barrier layer by applying a coating liquid containing polysilazane on a base material having gas permeability, drying the applied coating liquid to form a film, and then by irradiating the film with vacuum ultraviolet light; and
forming a protective layer by applying a coating liquid containing polysiloxane on the water vapor barrier layer, drying the applied coating liquid to form a film, and then by irradiating the film with vacuum ultraviolet light.

8. An electronic equipment, containing an electronic device sealed with the water vapor barrier film according to any one of Claims 1 to 6, or a water vapor barrier film produced by the production method according to Claim 7.
